# EUROPEAN PATENT SPECIFICATION

(11) **EP 3 879 290 B1**
(45) Date of publication and mention of the grant of the patent: **11.09.2024**
(21) Application number: 20163142.1
(22) Date of filing: 13.03.2020
(51) Int. Cl.: G01R 31/34, G01R 33/00, G01R 33/12

(54) **TESTING DEVICE FOR A MAGNETIZABLE CORE AND METHOD FOR TESTING SUCH CORE**
TESTVORRICHTUNG FÜR EINEN MAGNETISIERBAREN KERN UND VERFAHREN ZUM TESTEN SOLCH EINES KERNS
DISPOSITIF DE TEST POUR UN NOYAU MAGNÉTISABLE ET PROCÉDÉ POUR TESTER UN TEL NOYAU

(43) Date of publication of application: 15.09.2021
(73) Proprietor: Dr. Brockhaus Messtechnik GmbH & Co. KG, 58507 Lüdebscheid (DE)
(72) Inventor: Klimczyk, Piotr, 42-280 Czestochowa (PL); Mierczak, Lukasz, 42-280 Czestochowa (PL)
(74) Representative: Taruttis, Tilman

(56) References cited:
- WO-A1-2018/173211
- JP-A- S58 147 660
- US-A- 3 206 738
- US-A- 5 045 779
- US-A1- 2012 206 162

## Description

The present invention relates to a testing device and a respective method for determining magnetic properties of a magnetizable core.

Electric machines, i.e. motors as well as generators, usually comprise stator and rotor made of magnetizable material. Therefore, the performance of an electric machine depends on the magnetic properties of the magnetizable stator and rotor cores. Stator and rotor cores of electrical machines are typically formed by a plurality of laminated sheets made of magnetic material that are electrically isolated from each other to prevent eddy currents to spread across neighboring sheets of the core, which generate additional power loss in electrical machines. Hence, during the manufacturing of an electric motor or generator the cores of the stator and/or rotor are measured/inspected to identify their electrical and magnetic properties. In particular, the laminated cores are tested for electrical short circuits between adjacent sheets, and also characterized in terms of their magnetic properties, such as power loss and permeability.

Note that laminated core is a common denomination for a magnetizable core. However, in the following this term shall describe a core of any magnetizable material, e.g. solid cores made of soft magnetic composites, low carbon steel or FeCo, not just a laminated core.

WO 2012/161760 discloses a method and system for evaluating the condition of a laminated core of an electric machine, wherein the system discloses a first yoke wound with a first winding and having a first pair of arms spanning between a first pair of teeth of the laminated core. A second yoke wound with a second winding and having a second pair of arms spanning between a second pair of teeth. A power supply provides power to an electrical circuit defined by one of the first and second windings to produce a magnetic flux in the yoke corresponding to the one of the first and second windings thus defining an excitation yoke. A monitoring module provides a measurement of characteristics of an electrical circuit defined by the respective other one of the first and second windings to identify a fault corresponding to an eddy current between individual laminations in the laminated core.

WO02/10737 discloses a system and a respective method for detecting core faults, wherein a magnetic yoke is positioned near at least one tooth of the core under test. The yoke is wound by a winding and current is supplied to the winding to inject magnetic flux into the at least one tooth of the core. The system furthermore measures a signal resulting from the injected magnetic flux and uses the measured signal to detect core faults.

WO 2014106912 discloses a method for evaluating a core, wherein a magnetic yoke having an excitation winding is positioned near a pair of adjacent teeth of the core and wherein a current is supplied to the excitation winding for injecting a magnetic flux into the core. The system furthermore comprises a magnetic flux sensor for measuring a signal caused by the injected magnetic flux. Based on the measured magnetic flux the properties of the core are determined.

WO2018173211 A1 describes a measurement device for measuring the torque and efficiency of the magnetic coupling between a rotor and a stator of an electric motor.

US5045779 A describes a method and apparatus for testing dynamoelectric machine rotors, particularly squirrel cage rotors for induction motors to obtain resistance, reactance and effective skew value to identify rotor defects.

US3206738 A discloses an electrical position-encoding apparatus and systems including such apparatus.

JP S58 147660 A describes a testing method for a cage rotor
However, conventional devices and systems as described above do not provide a comprehensive testing method for a magnetic characterization of the complete magnetizable cores of stators and rotors, and simultaneous local magnetic characterization of the individual segments of those cores comprising sections of cores' back iron and a defined number of teeth.

This problem is solved by a testing device according to independent claim 1 and by a method for identifying magnetic properties of a magnetizable core under test according to independent claim 11.

In the following various embodiments of the testing device are described with respect to the figures, wherein
- Fig. 1: depicts a sectional view of a first embodiment of a magnetizable core and of coils of a testing device and a stator under test;
- Fig. 2: depicts a schematic view of magnetic flux;
- Fig. 3: depicts a sectional view of a second embodiment of a magnetizable core and coils of a testing device and a stator under test;
- Fig. 4: depicts a perspective view of a third embodiment of a magnetizable core and coils of a testing device and a stator under test;
- Fig. 5: depicts a sectional view of a third embodiment of a magnetizable core of an inner stator tester and an outer stator under test;
- Fig. 6: depicts a sectional view of a fourth embodiment of a magnetizable core of an inner stator tester and an outer stator under test;
- Fig. 7: depicts a sectional view of a fifth embodiment of a magnetizable core of an outer stator tester and an inner stator under test;
- Fig. 8: depicts a sectional view of a sixth embodiment of a magnetizable core of an outer stator tester and an inner stator under test.

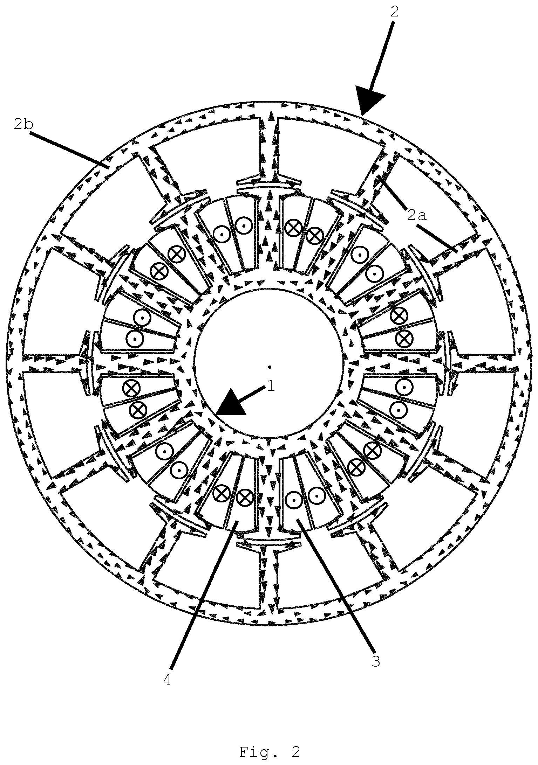

The figures depict sectional views of various arrangements of a magnetizable core and coils of the testing device and a respective magnetizable stator or rotor core under test, wherein Fig. 2 depicts a schematic illustration of magnetic flux in one embodiment. Note that identical reference numbers denote the same objects throughout the figures.

The embodiments have in common that the testing device comprises a measurement control unit. The measurement control unit is electrically coupled to the excitation coils for providing an excitation current to the excitation coils to produce a magnetic flux in the magnetizable core and magnetizable core under test. Accordingly, the control is adapted and configured for providing an excitation current to the excitation coils. Furthermore, the control is adapted and configured for conditioning of measured voltages induced by the time-varying magnetic flux. The control unit is electrically coupled to sensing coils comprised in the testing device. However, in an alternative example not forming part of the claimed subject-matter, the control unit can be electrically coupled to sensing coils wound directly on a magnetizable core under test or sampled at the surface of a core under test with a suitable measurement probe.

Note that neither the control unit nor the wiring of the coils is depicted in the figures.

For providing a magnetic excitation field to a stator or rotor core under test the embodiments of the testing device each comprise a magnetizable core 1 and excitation coils. The magnetizable core can be formed from any magnetizable material, in both laminated and solid form. The magnetic properties of the magnetizable core of the testing device are known. Essentially the magnetizable core of the device is shaped as a toothed wheel.

The device under test 2, i.e. a stator or rotor core under test typically comprises a plurality of teeth 2a, wherein the teeth protrude from a ring-shaped element 2b, also referred in the following as back iron.

The embodiment of the testing device is designed to test properties of teeth and back iron of the stator or rotor under test as depicted in the figures. The teeth of the testing device are designed for magnetic coupling to the teeth of the stator or rotor under test via an air gap as depicted in the figures.

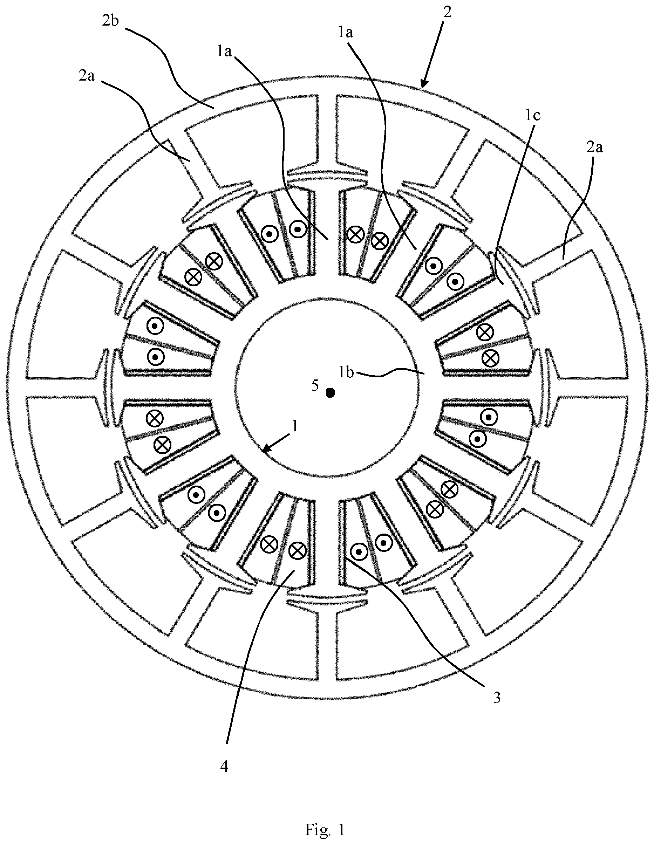

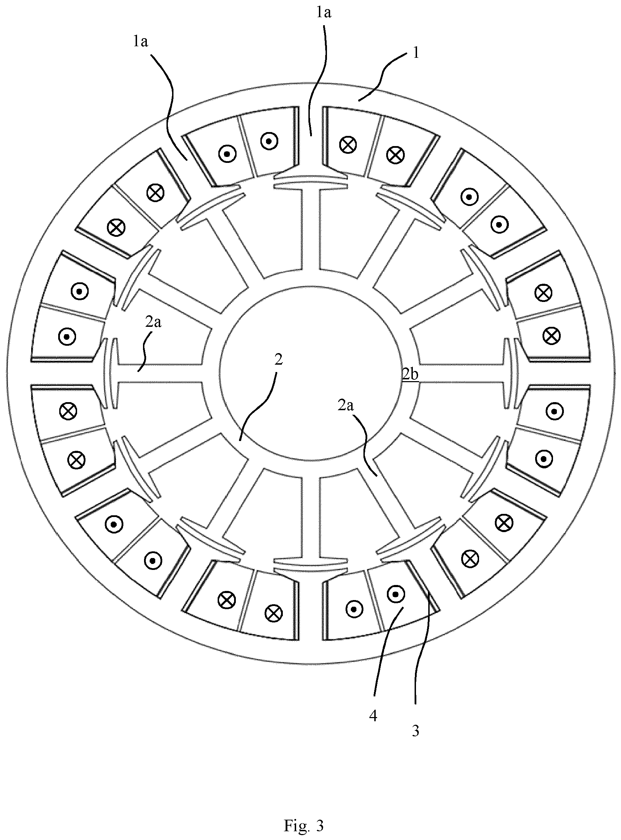

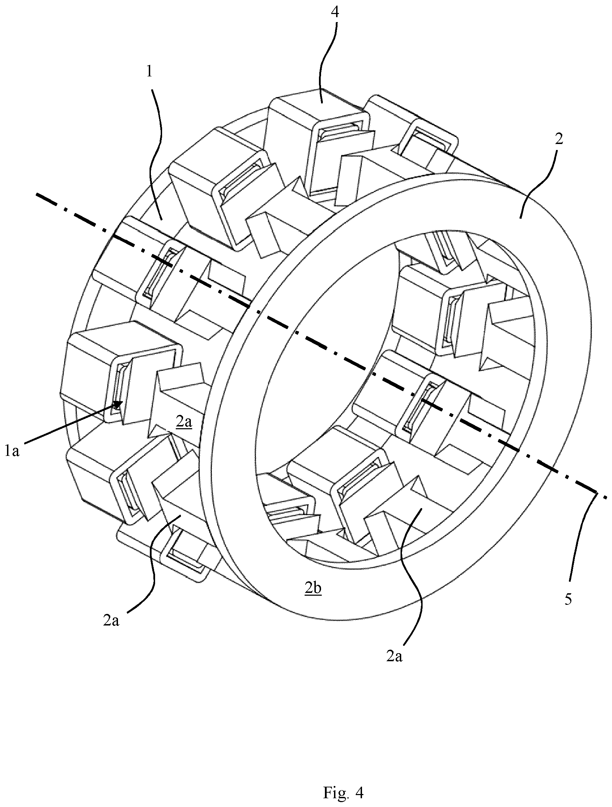

The teeth 1a of the magnetizable core 1 of the testing device are magnetically coupled for example by a ring-shaped element 1 b, i.e. back iron, of magnetizable material that provides a closed path for the magnetic flux. In case the magnetizable core of the testing device is a laminated core, the laminated sheets may form the ring-shaped element. Teeth 1a of the magnetizable core 1 extend from the ring-shaped element 1b in the direction of teeth 2a of the device under test 2. Note that in a first embodiment the teeth 1a of the magnetizable core of the testing device may protrude radially outwards, confer embodiment in Figs. 1, 5 and 6. In an alternative embodiment, the teeth 1a of the magnetizable core 1 of the testing device may protrude radially inwards, confer Figs. 3, 7 and 8. In still another embodiment the teeth 1a of the magnetizable core 1 of the testing device protrude in axial direction, confer Fig. 4, for axial magnetic coupling with teeth 2a of the device under test.

Teeth 1 a of the magnetizable core 1 of the testing device may have a top end shaped to reflect the shape of one or more top ends of a respective teeth of the stator or rotor under test in order to enable a best possible magnetic coupling to the stator or rotor under test 2 while maintaining a constant air gap between the teeth 1 a of the magnetizable core 1 of the testing device and the teeth 2a of the magnetizable core 2 under test.

Each tooth 1 of the magnetizable core 1 of the testing device carries a sensing coil 3, wherein the windings of each sensing coil 3 are wound around a tooth for measuring a voltage induced by a time-varying magnetic flux travelling through said tooth. Preferably, the windings of a sensing coil 3 extend along the length of the tooth, i.e. from the ring-shaped element 1b to the top end of a tooth. The sensing coil is electrically coupled to the measurement control unit of the testing device, which is not shown in the figures, and which provides the evaluation and conditioning of the sensed voltage signals.

Note that in alternative examples of a testing device not forming part of the claimed subject-matter, the teeth of the magnetizable core 1 do not carry a sensing coil 3, i.e. the testing device does not comprise sensing coils 3. In that case, voltages induced by a magnetic flux flowing through the device under test can be sampled directly from the sensing coils wound on the device under test.

Furthermore, each tooth 1 of the magnetizable core 1 of the testing device carries an excitation coil 4 for producing a magnetic excitation field. The windings of each excitation coil may cover the windings of the sensing coil 3 of a respective tooth 1a, at least partially, but alternatively can be wound adjacent to sensing coil 3. Note that in a preferred embodiment the windings of the excitation coils 4 and the respective current flow of adjacent teeth are arranged to produce a magnetic excitation field that is directed outbound at a first tooth and inbound at an adjacent tooth. In one embodiment the windings of excitation coils of neighbouring teeth have an opposite direction of winding and the excitation coils are electrically coupled in series. In this way the magnetic flux coupled into a device under test is well defined.

Note that excitation coils 4 as well as the sensing coils 3 can be customized according to the specifics of the device under test.

In one embodiment, confer Fig. 1, the magnetizable core 1 of the testing device comprises a ring-shaped element 1b and a plurality of radially outward protruding teeth 1a. The magnetizable core thus is essentially shaped as a toothed wheel, wherein the teeth protrude radially outwards. Each tooth carries a sensing coil 3 which may be covered at least partially by an excitation coil 4. The windings of the excitation coils of adjacent teeth are of opposite winding direction as depicted in Fig. 1, thus producing a magnetic field that is outbound at one tooth and inbound at the adjacent teeth.

The geometry of the magnetizable core 1, cf. Figs 1 and 5, 6, is adapted to the geometry of the device under test at least to the extent, that the outer diameter of the magnetizable core 1 can be placed inside the device under test, wherein there shall be a small air gap between teeth of the magnetizable core of the testing device and corresponding teeth of the device under test. However, please note that in this embodiment the height of the magnetizable core, i.e. in axial direction, may differ from the height of the device under test. In particular, the magnetizable core of the testing device may have a smaller height than the height of the magnetizable core under test.

The magnetic properties of the device under test 2 can be measured by producing a magnetic flux in the testing device by providing an excitation current to the excitation coils 4, thus producing a magnetic flux, magnetically coupling the magnetizable core 1 with magnetizable core 2 of the device under test. The time-varying magnetic flux passing through a tooth of the testing device produces a voltage in the respective sensing coil 3 wound on that tooth, wherein the induced voltage reflects the magnitude of the magnetic flux passing through the area enclosed by the sensing coil 3.

The voltages measured at the sensing coils are evaluated by a measurement control unit comprised in the testing device, wherein the magnetic and electronic properties of the testing device are known.

Fig. 2 depicts an example of distribution of magnetic flux as produced by the testing device according to Fig. 1 and coupled to a device under test 2. The arrows schematically depict the direction of magnetic flux, wherein the device under test 2 is in ideal state, i.e. the magnetic flux in the device under test 2 is free of any faults that could produce any irregularities of the magnetic flux. The magnetic flux is thus symmetrical within the testing device 2 and in the device under test. Due to the symmetric magnetic flux, the amplitude of the voltage induced in each sensing coil 3 is identical under the assumption that the coils are identical.

However, since any disturbance of the magnetic flux in the device under test produces a respective disturbance of the magnetic flux in the testing device, and consequently in the teeth of the testing device, any non-symmetry in the magnetic properties of the device under test can be detected by evaluating the voltages of the sensing coils 3. For example, if the device under test is a laminated core, a local short-circuit between layers causes magnetic non-symmetry that distorts the magnetic flux within device under test. Since the magnetic flux of the device under test is coupled to the magnetizable core of the testing device, the non-symmetry in the device under test produces a distortion of the magnetic flux in the magnetizable core of the testing device, which in turn is reflected in the voltages measured at the sensing coils 3. By evaluating the voltages induced in the sensing coils 3, magnetic flux distortions in the device under test that may be caused by undesired local variations in magnetic properties can be detected.

Fig. 3 depicts a schematic cross-sectional view of a second embodiment of another embodiment of the magnetizable core 1, excitation coils 4 and sensing coils 3 as well as a device under test 2.

In this embodiment the device under test 2 comprises a plurality of teeth 2a protruding radially outwards from a back iron 2b.

Similar as in Fig. 1, the magnetizable core 1 of the testing device is basically shaped as a toothed wheel having a plurality of teeth 1a. Each tooth 1a carries a sensing coil 3 and an excitation coil 4, wherein an excitation coil 4 may cover the sensing coil of a respective tooth 1a. The teeth 1a of the magnetizable core 1 are adjacent to the teeth 2a of the device under test 2 and separated by a pre-defined air-gap. Furthermore, the shape of the head-ends of the teeth of the magnetizable core 1 is adapted to the shape of the head ends of the teeth of the device under test. Here, the head ends are both shaped as hammer heads.

However, in difference to the arrangement depicted in Fig. 1, the device under test 2 is arranged within the magnetizable core 1 of the testing device and the teeth 2a of the device under test radially protrude in outbound direction while the teeth 1a of the magnetizable core 1 of the testing device radially protrude inwards As described with reference to the arrangement according to Fig. 1, the magnetizable core 1 of the testing device in this embodiment is designed to correspond to the design of the device under test regarding the geometry.

The steps for measuring the magnetic properties of the device under test are those as described above and with reference to Fig. 1.

Fig. 4 depicts a perspective schematic view of a third embodiment in which the magnetizable core 1 of the testing device and the device under test are arranged in an axial arrangement, i.e. the magnetizable core 1 and the device under test are arranged in series in axial direction of a shared axis of symmetry 5.

The device under test 2 comprises a plurality of teeth 2a that protrude from a ring-shaped back iron 2b in a direction parallel to axis 5.

Note that axis 5 is an axis of symmetry only, i.e. the device under test as well as the magnetizable core 1 of the testing device do not rotate while any testing is performed as described with reference to the embodiment depicted in Fig. 1. Instead, the magnetizable core 1 of the testing device and the core 2 under test are arranged such that teeth of the core under test 2 are placed next to a respective teeth of the magnetizable core 1 of the testing device, wherein a predefined air gap is maintained between the head ends of the teeth.

The magnetic core 1 of the testing machine comprises a plurality of teeth 1a protruding from a ring-shaped back iron element 1b in axial direction, confer axis of symmetry 5. Similarly, as described above, each tooth 1a carries an excitation coil 4 and optionally a sensing coil, wherein an excitation coil 4 may cover a respective sensing coil 3.

The magnetizable core 1 and the device under test 2 are arranged such that teeth 2a, i.e. the head end of each tooth, of the device under test is positioned close to teeth 1a of the magnetizable core 1 of the testing device, thus making it possible to magnetically couple by magnetic flux passing through the air gap between device under test 2 to the magnetizable core 1.

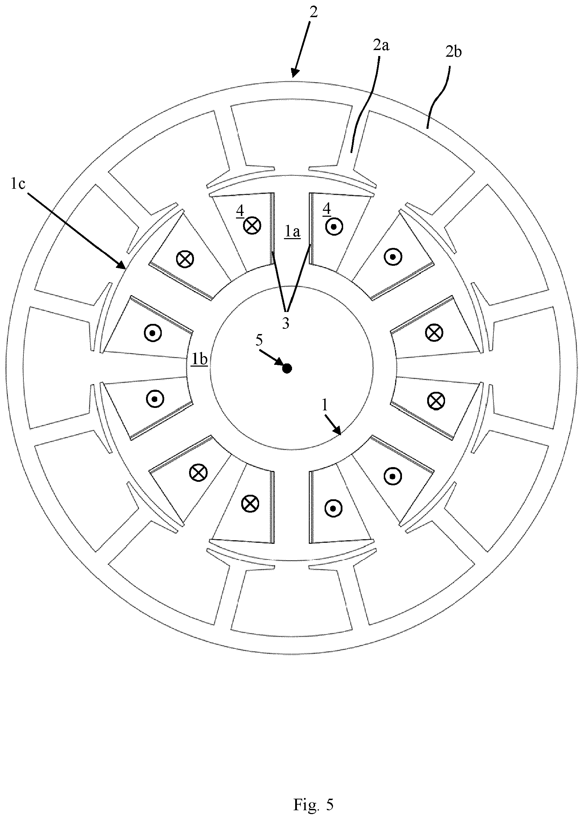

Figure 5 depicts a sectional view of third embodiment of a magnetizable core 1 of a testing device. Similar as depicted in Fig. 1, the magnetizable core is shaped and configured as an inner stator tester, i.e. the teeth 1a of the magnetizable core 1 are directed radially outwards for testing a stator or rotor 2 having its teeth direction radially inwards. Further, similar as above described for Fig. 1, each tooth 1a of the magnetizable core carries a sensing coil 3 and an excitation coil 4, wherein the winding directions of the excitation coils 4 of adjacent teeth may have opposite winding directions. Accordingly, the magnetic flux produced in adjacent teeth 1a of the magnetizable core 1 is of opposite direction.

However, the number of teeth 1a magnetizable core 1 of the testing device is less than the number of teeth 2a of the magnetizable core under test, i.e. in this embodiment the number of teeth of the core 2 under test is two times the number of teeth of the testing device.

In this embodiment the teeth 1a including the top end of each tooth of the magnetizable core are shaped to magnetically couple more than one tooth of the magnetizable core under test 2, i.e. the circumferential length of each top end 1c is adapted to magnetically couple two teeth of the magnetizable core 2 under test. Accordingly, when the magnetizable core 1 magnetically couples to a magnetizable core under test 2, the magnetic flux produced by one tooth 1a of the magnetizable core 1 of the testing device enters the magnetizable core 2 under test via two adjacent teeth 2a. Similarly, there will be two adjacent teeth where magnetic flux leaves the magnetizable core 2 under test to link the magnetizable core 1 via one tooth 1a of the testing device. In this way, teeth 2a of the magnetizable core under test are tested in pairs.

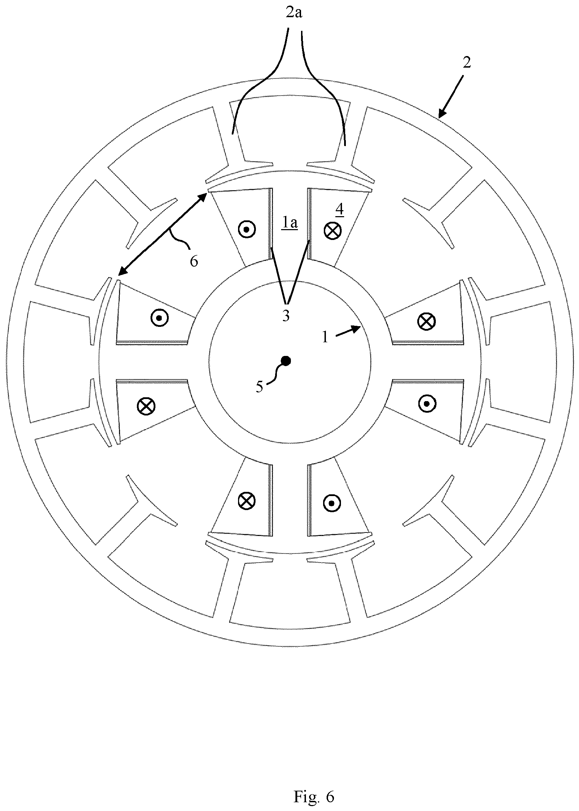

Fig. 6 depicts a sectional view of a fourth embodiment of a magnetizable core 1 of a testing device. Similar as in Fig. 1 and Fig. 5, the magnetizable core 1 of the testing device is an inner stator, wherein each tooth 1a carries a sensing coil 3 and an excitation coil 4, wherein the winding direction of excitation coils of adjacent teeth have opposite winding direction. Similar as in the embodiment depicted in Fig. 5, the top end of a tooth 1a is shaped to allow a magnetic coupling to more than one tooth 2a of the magnetic core under test. However, in this embodiment, the teeth 1a of the core of the testing device are shaped and separated by an air gap 6 corresponding to width of pre-defined section of stator under test (i.e. tooth and section of back iron). In one embodiment, the circumferential length of the air gap 6, i.e. the circumferential distance between top ends of adjacent teeth of the magnetizable core 1 of the testing device, is related to the circumferential length of pre-defined section of stator under test, comprising a pre-defined number of teeth and section of back iron.

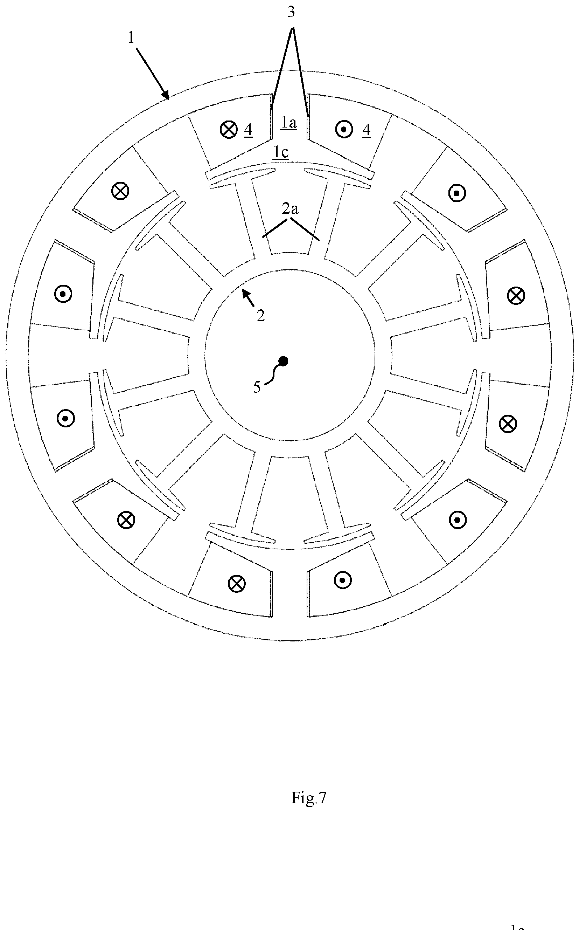

Fig. 7 depicts a sectional view of a fifth embodiment of a magnetizable core 1 of a testing device, wherein the magnetizable core 1 is designed for an outer stator tester, i.e. the teeth 1a of the magnetizable core 1 are directed radially inwards and the teeth 2a of the core under test are directed radially outwards, similar as in above described Fig. 3. The teeth 1a of the magnetizable core of the testing device each carry a respective excitation coil 4 and a respective sensing coil 3. However, in contrast to the arrangement depicted in Fig. 3, the teeth 1a of this embodiment are designed to magnetically couple to at least two teeth 2a of the magnetizable core under test, similar as in above described Fig. 5.

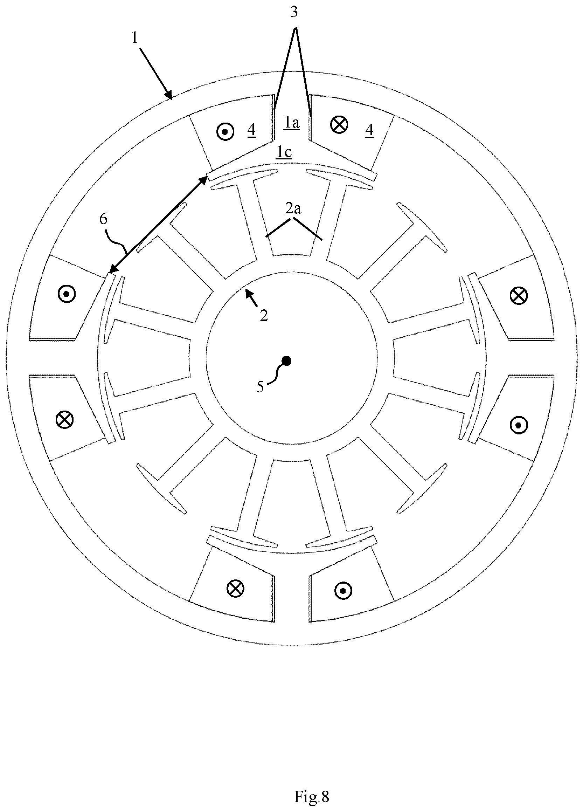

Fig. 8 depicts a sectional view of a sixth embodiment of a magnetizable core 1 of a testing device. Similar to that described with reference to Fig. 7, this embodiment of the magnetizable core is designed for an outer stator tester. However, in this embodiment, the teeth of this core may exhibit an air gap 6 between the top ends 1c of adjacent teeth, wherein the length of the air gap 6 is equal to or greater than the circumferential length of a top end 1c of a tooth 1a of the magnetizable core 1. Accordingly, the magnetic flux provided by magnetizable core 1 of this embodiment does not couple to all teeth of the magnetizable core 2 under test simultaneously, but may leave at least one tooth of the magnetizable core under test unmagnetized, i.e. without a magnetic coupling to a counterpart tooth 1a of a core 1 of the testing device.

The procedure for testing a stator or rotor 2 using above described testing device commences with providing a suitable testing device, i.e. a testing device comprising a magnetizable core adapted to the device under test. The magnetizable core 1 is then positioned relative to the device under test, typically a laminated core, as described above.

In case of a radial arrangement of the magnetizable core 1 and the device under test, confer Figures, and if the axial length of the magnetizable core 1 of the testing device is smaller than the axial length of the device under test, the magnetizable core 1 can be used to measure the magnetic properties of the device under test based on a plurality of measurements in different positions, i.e. the magnetizable core 1 and the magnetizable core 2 under test can be moved relative and in axial direction to another into various positions to determine the magnetic properties of the device under test in axial layers. That is, in case the axial length of the magnetizable core 1 is smaller, then the magnetizable core 1 can be used to determine the magnetic properties of the core under test in a plurality of measurements, i.e. for different axial sections of the core under test.

When the magnetizable core 1 and the core under test are positioned relative to each other, a current is provided to the excitation coils of the magnetizable core 1 of the testing device. Typically, the current provided to the ideally identical excitation coils of the magnetizable core 1 is the same for all excitation coils and is provided at the same time to produce a symmetric magnetic field in magnetizable core 1. This can be achieved by coupling the excitation coils in series. The core under test and the magnetizable core 1 are arranged such that the produced magnetic flux couples into the core under test through the air gap between the teeth 1a of the magnetic core 1 of the testing device and the teeth 2a of the magnetic core of the device under test. In this way the produced magnetic flux is enclosed within the magnetic circuits formed by the teeth and back iron of magnetizable core 1 and the teeth and back iron of the core under test.

In case that at least one tooth 2a of a core 2 under test is left unmagnetized , confer Figs. 6 and 8, the test procedure may comprise at least one step of rearranging the cores relative to each other to provide for testing the magnetic properties of a previously unmagnetized tooth of the core under test.

In one embodiment the magnitude of the magnetic flux is measured using sensing coils 3, i.e. the voltages induced in the sensing coils 3 are measured and the respective values are forwarded to the measurement control unit of the testing device for evaluation.

Note that in an alternative example of the testing device not forming part of the claimed subject-matter, respective voltages induced by the time-varying magnetic flux can be measured directly on the surface of the core under test, particularly on the teeth and the back iron of the core under test, for example by using a directly wound sensing coils or other suitable probe. The measured voltages are forwarded to the measurement control unit of the testing device.

The measured signals are controlled within a feedback loop, wherein the waveforms and amplitudes of the applied magnetizing current are adjusted to generate predefined waveforms and levels of measured magnetic flux density. The implemented feedback control thus ensures repeatable and reproducible measurement conditions.

Since the magnetizable core 1 of the testing device and the core under test are magnetically coupled, any variation in magnetic property of the core under test, that may be caused for example by local short-circuit between laminated sheets or residual stress, produces an aberration of the magnetic flux in the core under test, which is also reflected in the magnetic flux traversing the sensing coils 3 and consequently voltages induced in the sensing coils 3. Similarly, the irregularity produces an aberration of the induced voltage measurable on the surface of the magnetic core under test, which can be sampled with sensing coil or a suitable probe. In this way, i.e. by evaluating the voltages induced in the sensing coils 3 or sampled from the surface of the core under test, the magnetic properties of the core under test can be determined.

### List of reference numerals

- 1: magnetizable core comprised in testing device
- 1a: tooth/teeth of magnetizable core in testing device
- 1b: ring shaped element, also referred to as back iron of magnetizable core in testing device
- 1c: top end of tooth of magnetizable core in testing device
- 2: magnetizable core under test
- 2a: tooth/teeth of a magnetizable core under test
- 2b: ring shaped element, also referred to as back iron of magnetizable core of device under test
- 3: sensing coil of testing device
- 4: excitation coil of testing device
- 5: axis of symmetry
- 6: circumferential distance

## Claims

1. Testing device for identifying magnetic properties of a magnetizable core under test (2) having a plurality of protruding teeth, the testing device comprising
a magnetizable, toothed wheel shaped core (1) having a plurality of protruding teeth (1a), wherein each of the protruding teeth (1a) carries a respective excitation coil (4), and
each of the protruding teeth (1a) carries a respective sensing coil (3) for sensing a magnetic flux, and
a measurement control unit electrically connected to the excitation coils (4) for providing an excitation current to the excitation coils (4), electrically connected to each sensing coil (3) for measuring an induced voltage, and configured to evaluate the measured induced voltages to determine magnetic properties of the magnetizable core under test.

2. Testing device according to any preceding claim, wherein the top-end of each tooth of its magnetizable core is T-shaped.

3. Testing device according to any preceding claim, wherein each of the sensing coils (3) is wound around a tooth of the magnetizable, toothed wheel shaped core (1) of the testing device.

4. Testing device according to any preceding claim, wherein the excitation coils (4) are connected in series.

5. Testing device according to any preceding claim, wherein the winding direction of the excitation coils (4) of adjacent teeth (1a) is opposite.

6. Testing device according to claim 2 or 5, wherein each excitation coil (4) covers the sensing coil (3) of the respective tooth (1a).

7. Testing device according to any preceding claim, wherein the teeth of the magnetizable toothed wheel shaped core (1) of the testing device protrude radially outwards or radially inwards.

8. Testing device of any preceding claim, wherein the height of the magnetizable toothed wheel shaped core (1) of the testing device is equal or less than the height of the laminated core under test (2).

9. Testing device according to any of preceding claims 1 to 6, wherein the teeth (1a) of the magnetizable toothed wheel shaped core (1) of the testing device protrude axially.

10. Testing device according to any preceding claim, wherein the circumferential distance between top ends (1c) of adjacent teeth (1a) of the magnetizable core 1 is equal to or greater than the circumferential length of the top end (1c) of a tooth (1a) of the magnetizable toothed wheel shaped core (1) of the testing device.

11. Method for identifying magnetic properties of a magnetizable core (2) under test comprising
providing a testing device according to any previous claim, and
positioning teeth (1a) of the magnetizable core (1) of the testing device adjacent to respective teeth (2a) of a magnetizable core (2) under test, and
providing current to each excitation coil (4) thereby simultaneously generating magnetic flux in at least each tooth (1a) and back iron (1b) of the magnetizable, toothed wheel shaped core (2) of the testing device as well as in teeth (2a) and back iron (2b) of the magnetizable core (2) under test, and
sampling an induced voltag from each sensing coil (3) reflecting the magnitude of magnetic flux flowing in magnetic circuits comprising respective teeth (1a) and back iron (1b) of the magnetizable core (1)of the testing device and teeth (2a) and back iron (2b) of the laminated magnetizable core (2)of device under test; and
evaluating the plurality of sampled induced voltages to determine magnetic properties of the magnetizable core (2) under test.

12. The method according to claim 11, wherein the induced voltages are sampled from the sensing coil (3) of wound teeth (1a) of the magnetizable core of the testing device.

## Patentansprüche

1. Prüfvorrichtung zur Identifizierung der magnetischen Eigenschaften eines magnetisierbaren zu prüfenden Kerns (2), der eine Vielzahl von vorstehenden Zähnen aufweist, die Prüfvorrichtung umfassend
einem magnetisierbaren, zahnradförmigen Kern (1), der eine Vielzahl von vorstehenden Zähnen (1a) aufweist, wobei jeder der vorstehenden Zähne (1a) eine entsprechende Erregerspule (4) trägt, und
jeder der vorstehenden Zähne (1a) eine entsprechende Erfassungsspule (3) zum Erfassen eines magnetischen Flusses trägt, und
eine Messsteuereinheit, die elektrisch mit den Erregerspulen (4) verbunden ist, um den Erregerspulen (4) einen Erregerstrom bereitzustellen, die elektrisch mit jeder Erfassungsspule (3) verbunden ist, um eine induzierte Spannung zu messen, und die konfiguriert ist, um die gemessenen induzierten Spannungen auszuwerten, um die magnetischen Eigenschaften des zu prüfenden magnetisierbaren Kerns zu bestimmen.

2. Prüfvorrichtung nach einem der vorstehenden Ansprüche, wobei das obere Ende eines jeden Zahns des magnetisierbaren Kerns T-förmig ist.

3. Prüfvorrichtung nach einem der vorstehenden Ansprüche, wobei jede der Erfassungsspulen (3) um einen Zahn des magnetisierbaren, zahnradförmigen Kerns (1) der Prüfvorrichtung gewickelt ist.

4. Prüfvorrichtung nach einem der vorstehenden Ansprüche, wobei die Erregerspulen (4) in Reihe geschaltet sind.

5. Prüfvorrichtung nach einem der vorstehenden Ansprüche, wobei die Wicklungsrichtung der Erregerspulen (4) von benachbarten Zähnen (1a) entgegengesetzt ist.

6. Prüfvorrichtung nach Anspruch 2 oder 5, wobei jede Erregerspule (4) die Erfassungsspule (3) des jeweiligen Zahns (1a) überdeckt.

7. Prüfvorrichtung nach einem der vorstehenden Ansprüche, wobei die Zähne des magnetisierbaren zahnradförmigen Kerns (1) der Prüfvorrichtung radial nach außen oder radial nach innen ragen.

8. Prüfvorrichtung nach einem der vorstehenden Ansprüche, wobei die Höhe des magnetisierbaren zahnradförmigen Kerns (1) der Prüfvorrichtung gleich oder geringer ist als die Höhe des laminierten zu prüfenden Kerns (2).

9. Prüfvorrichtung nach einem der vorstehenden Ansprüche 1 bis 6, wobei die Zähne (1a) des magnetisierbaren zahnradförmigen Kerns (1) der Prüfvorrichtung axial vorstehen.

10. Prüfvorrichtung nach einem der vorstehenden Ansprüche, wobei der Umfangsabstand zwischen den oberen Enden (1c) benachbarter Zähne (1a) des magnetisierbaren Kerns 1 gleich oder größer ist als die Umfangslänge des oberen Endes (1c) eines Zahns (1a) des magnetisierbaren zahnradförmigen Kerns (1) der Prüfvorrichtung.

11. Verfahren zur Identifizierung der magnetischen Eigenschaften eines magnetisierbaren zu prüfenden Kerns (2), umfassend
Bereitstellen einer Prüfvorrichtung nach einem der vorstehenden Ansprüche, und
Positionieren von Zähnen (1a) des magnetisierbaren Kerns (1) der Prüfvorrichtung benachbart zu entsprechenden Zähnen (2a) eines magnetisierbaren zu prüfenden Kerns (2), und
Bereitstellen von Strom für jede Erregerspule (4), wodurch gleichzeitig ein magnetischer Fluss in mindestens jedem Zahn (1a) und dem hinteren Eisen (1b) des magnetisierbaren, zahnradförmigen Kerns (2) der Prüfvorrichtung sowie in den Zähnen (2a) und dem hinteren Eisen (2b) des magnetisierbaren zu prüfenden Kerns (2) erzeugt wird, und
Abtasten einer induzierten Spannung von jeder Erfassungsspule (3), die die Größe des magnetischen Flusses widerspiegelt, der in magnetischen Kreisen fließt, die jeweils Zähne (1a) und hinteres Eisen (1b) des magnetisierbaren Kerns (1) der Prüfvorrichtung und Zähne (2a) und hinteres Eisen (2b) des laminierten magnetisierbaren Kerns (2) der zu prüfenden Vorrichtung umfassen; und
Auswerten der Vielzahl der abgetasteten induzierten Spannungen zur Bestimmung der magnetischen Eigenschaften des magnetisierbaren zu prüfenden Kerns (2).

12. Verfahren nach Anspruch 11, wobei die induzierten Spannungen von der Erfassungsspule (3) der gewickelten Zähne (1a) des magnetisierbaren Kerns der Prüfvorrichtung abgetastet werden.

## Revendications

1. Dispositif d'essai destiné à identifier les propriétés magnétiques d'un noyau magnétisable sous essai (2) ayant une pluralité de dents saillantes, le dispositif d'essai comprenant
un noyau magnétisable en forme de roue dentée (1) ayant plusieurs dents saillantes (1a), dans lequel chacune des dents saillantes (1a) porte une bobine d'excitation respective (4), et
chacune des dents saillantes (1a) porte une bobine de détection respective (3) pour détecter un flux magnétique, et
une unité de commande des mesures connectée électriquement aux bobines d'excitation (4) pour fournir un courant d'excitation aux bobines d'excitation (4), connectée électriquement à chaque bobine de détection (3) pour mesurer une tension induite, et configurée pour évaluer les tensions induites mesurées afin de déterminer les propriétés magnétiques du noyau magnétisable soumis à l'essai.

2. Dispositif d'essai selon l'une quelconque revendication précédente, dans lequel l'extrémité supérieure de chaque dent de son noyau magnétisable est en forme de T.

3. Dispositif d'essai selon l'une quelconque revendication précédente, dans lequel chacune des bobines de détection (3) est enroulée autour d'une dent du noyau magnétisable en forme de roue dentée (1) du dispositif d'essai.

4. Dispositif d'essai selon l'une quelconque revendication précédente, dans lequel les bobines d'excitation (4) sont connectées en série.

5. Dispositif d'essai selon l'une quelconque revendication précédente, dans lequel le sens d'enroulement des bobines d'excitation (4) des dents adjacentes (1a) est opposé.

6. Dispositif d'essai selon la revendication 2 ou 5, dans lequel chaque bobine d'excitation (4) couvre la bobine de détection (3) de la dent respective (1a).

7. Dispositif d'essai selon l'une quelconque revendication précédente, dans lequel les dents du noyau en forme de roue dentée magnétisable (1) du dispositif d'essai font saillie radialement vers l'extérieur ou vers l'intérieur.

8. Dispositif d'essai selon l'une quelconque revendication précédente, dans lequel la hauteur du noyau magnétisable en forme de roue dentée (1) du dispositif d'essai est égale ou inférieure à la hauteur du noyau stratifié soumis à l'essai (2).

9. Dispositif d'essai selon l'une quelconque des revendications précédentes 1 à 6, dans lequel les dents (1a) du noyau en forme de roue dentée magnétisable (1) du dispositif d'essai font saillie axialement.

10. Dispositif d'essai selon l'une quelconque revendication précédente, dans lequel la distance circonférentielle entre les extrémités supérieures (1c) des dents adjacentes (1a) du noyau magnétisable 1 est égale ou supérieure à la longueur circonférentielle de l'extrémité supérieure (1c) d'une dent (1a) du noyau magnétisable en forme de roue dentée (1) du dispositif d'essai.

11. Procédé d'identification des propriétés magnétiques d'un noyau magnétisable (2) sous essai comprenant
la fourniture d'un dispositif d'essai selon l'une quelconque revendication précédente, et
le positionnement des dents (1a) du noyau magnétisable (1) du dispositif d'essai à proximité des dents respectives (2a) d'un noyau magnétisable (2) soumis à l'essai, et
la fourniture d'un courant à chaque bobine d'excitation (4), générant ainsi simultanément un flux magnétique dans au moins chaque dent (1a) et fer arrière (1b) du noyau magnétisable en forme de roue dentée (2) du dispositif d'essai, ainsi que dans les dents (2a) et fer arrière (2b) du noyau magnétisable (2) sous essai, et
l'échantillonnage d'une tension induite à partir de chaque bobine de détection (3) reflétant l'ampleur du flux magnétique circulant dans les circuits magnétiques comprenant les dents (1a) et le fer arrière (1b) respectifs du noyau magnétisable (1) du dispositif d'essai et les dents (2a) et le fer arrière (2b) du noyau magnétisable stratifié (2) du dispositif sous essai ; et
l'évaluation de la pluralité de tensions induites échantillonnées pour déterminer les propriétés magnétiques du noyau magnétisable (2) sous essai.

12. Procédé selon la revendication 11, dans lequel les tensions induites sont échantillonnées à partir de la bobine de détection (3) des dents enroulées (1a) du noyau magnétisable du dispositif d'essai.
